# EUROPÄISCHE PATENTSCHRIFT

(11) **EP 1 182 702 B1**
(45) Veröffentlichungstag und Bekanntmachung des Hinweises auf die Patenterteilung: **03.01.2007**
(21) Anmeldenummer: 00117931.6
(22) Anmeldetag: 21.08.2000
(51) Int. Cl.: H01L 23/58

(54) **Vorrichtung zum Schutz einer integrierten Schaltung**
Device for the Protection of an Integrated Circuit
Dispositif pour la protection d'un circuit intégré

(43) Veröffentlichungstag der Anmeldung: 27.02.2002
(73) Patentinhaber: Infineon Technologies AG, 81669 München (DE)
(72) Erfinder: Taddiken, Hans, 81737 München (DE); Laackmann, Peter, 81541 München (DE)
(74) Vertreter: Epping - Hermann - Fischer

(56) Entgegenhaltungen:
- WO-A-00/28399
- US-A- 4 293 778
- US-A- 4 868 489
- US-A- 5 406 630
- US-A- 5 892 369
- US-A- 6 078 537

## Beschreibung

Die vorliegende Erfindung betrifft eine Vorrichtung zum Schutz einer in einem Substrat ausgebildeten, integrierten Schaltung mit einem Shield, das die integrierte Schaltung zumindest teilweise abdeckt und das einen Signalsender, einen Signalempfänger, wenigstens zwei zwischen dem Signalsender und dem Signalempfänger verlaufende Leiterzüge und eine mit dem Signalsender und dem Signalempfänger verbundene Ansteuer- und Auswerteeinrichtung aufweist sowie mit einer auf dem Substrat aufgebrachten Abdeckung.

Es ist möglich, eine integrierte Schaltung einer Analyse, dem sogenannten "Reverse Engineering", zu unterziehen. Diese Analyse kann dazu dienen, lediglich die Funktionsweise zu analysieren oder aber die Funktionsweise zum Zwecke einer Manipulation eines Dateninhaltes oder des Funktionsablaufs zu beeinflussen. Zum Zwecke der Analyse wird in einem ersten Schritt zunächst das Material aufgelöst, welches die Oberfläche des Chips bedeckt. Dieses Material kann entweder eine Kunststoffpressmasse sein, welche das Gehäuse des Halbleiterbauelementes bildet, oder ein sogenannter "Globe Top", der lediglich dazu dient, die Chipoberfläche sowie die elektrischen Verbindungen gegen mechanische Beschädigungen zu schützen. Ein derartiger "Globe Top" wird beispielsweise bei Chipkartenmodulen verwendet. Auf der Passivierungsschicht des Chips ist weiterhin üblicherweise eine dünne Kunststoffschicht ("Imid", "Photoimid") aufgebracht. Auch diese Schicht wird bei einem Reverse-Engineering-Verfahren entfernt. Nach dem Entfernen des den Halbleiterchip umgebenden oder bedekkenden Materials ist in der Regel die Passivierungsschicht des Halbleiterchips zugänglich. Diese kann mittels Ätzverfahren, Laser- oder FIB-(Focused Ion Beam)Methoden selektiv entfernt werden. Hierdurch erhält man Zugang zu den Signalleitungen.

Eine Analyse der integrierten Schaltung ist prinzipiell unerwünscht. Insbesondere bei sicherheitsrelevanten Schaltungen, beispielsweise einem Mikrocontroller auf einer Chipkarte, der die Funktion einer elektrischen Geldbörse oder dergleichen beinhaltet, ist ein Reverse Engineering nach Möglichkeit zu unterbinden. In der Praxis existieren bereits verschiedene Verfahren, mit denen eine derartige Analyse zumindest erschwert werden kann. Zum Schutz einer integrierten Schaltung ist es bekannt, diese mit einem sogenannten Shield abzudekken. Ein Shield besteht dabei aus wenigstens zwei über der integrierten Schaltung verlaufenden Leiterbahnen. Bei den passiven Shields liegt an wenigstens einer der Leiterbahnen das Versorgungspotential des Halbleiterchips, an der anderen das Massepotential an. Eine Unterbrechung oder ein Kurzschluß dieser Leiterbahnen wird durch eine Auswerteschaltung detektiert, die dann die integrierte Schaltung in einen sicheren Zustand verbringt. Dies kann beispielsweise das Auslösen eines Resets oder das Löschen der Speicherinhalte sein. Bei den sogenannten aktiven Shields kann das an den jeweiligen Leiterzügen anliegende Signal durch eine Ansteuer- und Auswertevorrichtung variiert werden. Hierdurch wird die Sicherheit gegen eine Analyse gegenüber einem passiven Shield erhöht, da das Shield nicht durch einen Bypass oder eine Umverdrahtung funktionsunfähig gemacht werden kann. Der Verlauf der Leiterzüge kann dabei mäanderförmig oder gitterförmig in mehreren Ebenen realisiert sein.

Aus der WO 97/36326 ist ein Verfahren und eine Vorrichtung bekannt, mit dem die Entfernung eines aus Preßmasse bestehenden Kunststoffgehäuses detektiert werden kann. Dabei wird die sich ändernde Kapazität zwischen zwei Leiterzügen beim Entfernen der Kunststoffpreßmasse detektiert. Zu diesem Zweck ist eine Mehrzahl an Sensoren in dem Kunststoff-Preßmassengehäuse vorgesehen. Diese sind jedoch bereits vor dem Entfernen der Kunststoff-Preßmasse leicht zu ermitteln, und können deshalb selektiv beim Entfernen des Gehäuses ausgespart werden, so daß eine Änderung der Kapazität nicht detektiert werden kann.

Weiterhin ist aus der US 4,868,489 ein Verfahren bekannt, das die Entfernung der Passivierungsschicht über die Chipoberfläche detektiert. Hierzu sind mehrere, verhältnismäßig groß ausgebildete Detektoren vorgesehen. Aufgrund deren Größe sind diese leicht erkennbar und somit umgehbar. Zudem weist die in dem genannten US-Patent dargestellte Anordnung den Nachteil auf, daß ein die integrierte Schaltung abdeckendes Shield an den Stellen, an denen sich die Detektoren befinden, jeweils eine Aussparung aufweisen muß. Hierdurch ergeben sich Schwachstellen, an denen eine Analyse ermöglicht wird.

Aus der WO 00/28399 A1 ist eine Schutzschaltung für eine integrierte Schaltung bekannt. Diese Schutzschaltung ist in einer oder mehreren Schaltungsebenen unterhalb oder oberhalb der integrierten Schaltung angeordnet und weist mehrere Leiterbahnen auf. Diese werden mit unterschiedlichen Signalen eines oder mehrerer Signalgeneratoren beaufschlagt und mit einem oder mehreren Detektoren, die die unterschiedlichen Leiterbahnen übertragenden Signale auf ein Fehlverhalten ausgewertet. Im Falle eines Feststellens eines solchen Fehlverhaltens wird ein Steuersignal zur Überführung der integrierten Schaltung in einen Sicherheitsmodus ausgegeben.

Die Aufgabe der vorliegenden Erfindung besteht deshalb darin, eine Vorrichtung zum Schutz einer in einem Substrat ausgebildeten integrierten Schaltung vorzuschlagen, mit der ein verbesserter Schutz gegen eine Analyse möglich ist. Weiterhin soll ein Verfahren zum Schutz einer derartigen integrierten Schaltung gegen Reverse Engineering vorgeschlagen werden.

Diese Aufgabe wird mit den Merkmalen des Patentanspruches 1 (Vorrichtung) beziehungsweise des Patentanspruches 12 (Verfahren zum Schutz der Vorrichtung) gelöst. Vorteilhafte Ausgestaltungen ergeben sich aus den untergeordneten Patentansprüchen.

Die Erfindung schlägt eine Vorrichtung zum Schutz einer in einem Substrat ausgebildeten, integrierten Schaltung mit einem aktiven Shield vor, bei der das Shield eine Schaltvorrichtung aufweist, wodurch in einem ersten Schaltzustand ein kapazitives Meßverfahren durchführbar ist und in einem zweiten Schaltzustand eine Beschädigung des Shields detektierbar ist.

Das aktive Shield ist somit erfindungsgemäß zwischen zwei Funktionen umschaltbar. Befindet sich die Schaltvorrichtung in dem zweiten Schaltzustand, so können Kurzschlüsse zwischen Leiterzügen oder unterbrochene Leiterzüge erkannt werden. Somit ist eine Manipulation an dem aktiven Shield erkennbar, wobei diese Funktionalität der üblichen Funktionsweise eines aktiven Shields entspricht.

Weist die Schaltvorrichtung den ersten Schaltzustand auf, so wird ein kapazitives Testverfahren zwischen zwei Signalleitungen durchgeführt. Beispielswiese wird eine der Leitungen mit einem Signal beaufschlagt, welches bei entsprechend hoher Kapazität zwischen den beiden Leitungen auf der zweiten Leitung von einer Auswerteschaltung detektiert werden kann. Das in den einen Leiterzug eingespeiste Signal kann dabei konstant sein, einen periodischen oder einen zufälligen Charakter besitzen.

Die erfindungsgemäße Vorrichtung weist den besonderen Vorteil auf, daß sich die beiden oben beschriebenen Meßverfahren gegenseitig schützen. Ein kapazitives Meßverfahren kann beispielsweise durch die Aufbringung von Kurzschlußbügeln zwischen zwei Leiterzügen mittels FIB-Methoden unterlaufen werden. Ein derartiger Angriff würde jedoch durch den "normalen" Betriebsmodus detektiert werden, wenn sich die Schaltvorrichtung in dem zweiten Schaltzustand befindet. Andererseits schützt das kapazitive Meßverfahren das herkömmliche aktive Shield-Verfahren, da für einen Angriff eine Entfernung der Abdeckmasse notwendig wäre, welche durch das kapazitive Meßverfahren detektiert wird.

Durch die Kombination zweier Detektionsverfahren, die lediglich das Vorsehen einer Schaltvorrichtung in einem aktiven Shield bedingt, kann der Schutz gegen eine Analyse einer integrierten Schaltung wesentlich erhöht werden. Da die beiden Meßverfahren im Gegensatz zum Stand der Technik nicht räumlich getrennt sind, führen auch lokal begrenzte Angriffe nicht mehr zum Ziel.

In einer vorteilhaften Ausgestaltung der Erfindung ist die Schaltvorrichtung lediglich in einem Teil der Leiterzüge vorgesehen. Die Schaltvorrichtung weist vorzugsweise mehrere Schalter auf, die jeweils in einem Leiterzug vorgesehen sind. Vorzugsweise ist jeweils ein Leiterzug mit einem Schalter und ein Leiterzug ohne Schalter derart benachbart angeordnet, daß eine kapazitive Kopplung möglich ist. Die kapazitive Kopplung muß dabei derart sein, daß ein in einen Leiterzug ohne Schalter eingespeistes Signal annähernd identisch an dem kapazitiv gekoppelten Leiterzug durch den Signalempfänger empfangen wird. Die zwei Leiterzüge können dabei in einer Variante unmittelbar benachbart zueinander verlaufen. Gemäß einer anderen Variante kann zwischen den zwei Leiterzügen zumindest ein weiterer Leiterzug gelegen sein. Dieser zumindest eine weitere Leiterzug ist vorteilhafterweise floatend, d.h. dieser wird nicht für das Meßverfahren genutzt. Durch diese Ausgestaltung kann eine größere kapazitive Kopplung zwischen den zwei Leiterzügen erzielt werden. Zwischen den zwei Leiterzügen können auch zumindest abschnittsweise Leiterzüge verlaufen, die für das Meßverfahren herangezogen werden.

Vorteilhafterweise sind die Schalter der Schaltvorrichtung mit der Ansteuer- und Auswerteeinrichtung verbunden und durch diese steuerbar. Ebenso ist zweckmäßigerweise der Signalempfänger des Shields mit der Ansteuer- und Auswerteeinrichtung verbunden. Die Schalter der Schaltvorrichtung und der Signalempfänger erhalten somit von der Ansteuer- und Auswertevorrichtung eine entsprechende Information, welches Meßverfahren durchgeführt werden soll. Der Signalempfänger, welcher Teil der Ansteuer- und Auswerteeinrichtung sein kann, ist dann in der Lage, zu unterscheiden, ob ein erwartetes Signal empfangen wird oder eine Manipulation von Außen durchgeführt wird.

In einer Ausgestaltung der Erfindung ist die Schaltvorrichtung Teil des Signalsenders. In diesem Falle wäre der Signalsender mit der Ansteuer- und Auswertevorrichtung verbunden.

Das erfindungsgemäße Verfahren zum Schutz einer in einem Substrat ausgebildeten integrierten Schaltung gegen "Reverse Engineering" umfaßt die folgenden Schritte:
a) Auswahl des Schaltzustandes der Schaltvorrichtung durch die Ansteuer- und Auswerteeinrichtung,
b) Anlegen jeweils eines Signales an die Leiterzüge durch die Sendeeinrichtung,
c) Auswerten des von dem Signalempfänger empfangenen Signals durch die Ansteuer- und Auswerteeinrichtung,
d) Herbeiführen eines Funktionswechsels der integrierten Schaltung, wenn die Auswertung des Signals durch die An steuer- und Auswerteeinrichtung ein unerwartetes Ergebnis ergibt,
e) Im Falle eines erwarteten Ergebnisses Wiederholen der Schritte 1 bis 4.

Vorzugsweise erfolgt die Wahl des Schaltzustandes der Schaltvorrichtung wahlweise oder alternierend durch die Ansteuer- und Auswertevorrichtung. Das Shield wechselt somit gemäß der Steuerung durch die Ansteuer- und Auswertevorrichtung zwischen dem kapazitiven Meßverfahren und dem normalen Betriebsmodus eines aktiven Shields.

Ein besonders guter Schutz wird dann erzielt, wenn sich der Schaltzustand der Schaltvorrichtung periodisch oder in zufälligen Zeitabständen ändert.

Eine weitere Erhöhung der Sicherheit wird dadurch ermöglicht, daß zumindest die an einem Leiterzug mit Schalter und an einem benachbarten Leiterzug ohne Schalter anliegenden Signale unterschiedlich sind, wenn sich die Schaltvorrichtung in dem zweiten Schaltzustand, das heißt in dem normalen Betriebsmodus, befindet.

Die Erfindung wird anhand der nachfolgenden beiden Figuren näher erläutert. Es zeigen:
- Figur 1: den prinzipiellen Aufbau der erfindungsgemäßen Vorrichtung zum Schutz einer in einem Substrat ausgebildeten integrierten Schaltung in einem normalen Betriebsmodus,
- Figur 2: eine prinzipielle Darstellung der erfindungsgemäßen Vorrichtung, in welchem das kapazitive Meßverfahren durchführbar ist und
- Figur 3: ein weiteres Ausführungsbeispiel der erfindungsgemäßen Vorrichtung.

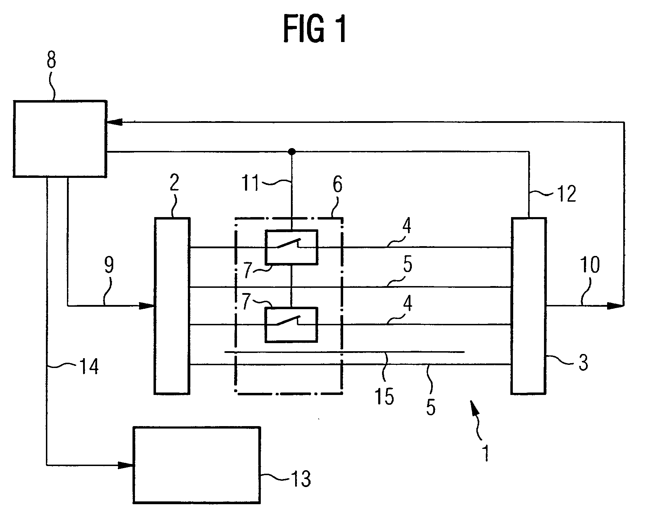

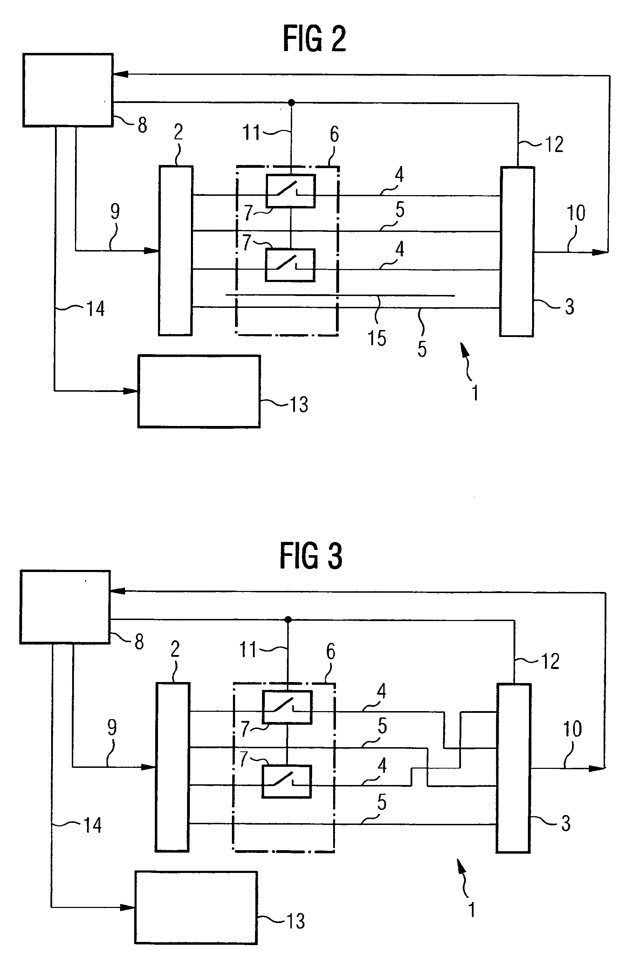

Die Figuren 1 und 2 zeigen den prinzipiellen Aufbau der erfindungsgemäßen Vorrichtung zum Schutz einer in einem Substrat ausgebildeten integrierten Schaltung. Die Figuren zeigen lediglich die funktionelle Zuordnung der einzelnen Elemente zueinander. Sie geben jedoch keine Lehre darüber, wie die gezeigten Elemente räumlich zueinander angeordnet sind.

Eine Möglichkeit, eine in einem Substrat integrierte Schaltung vor einer Analyse zu schützen, besteht darin, die integrierte Schaltung auf der vom Substrat abgewandten Hauptseite mit einem Shield zumindest teilweise abzudecken. Es sind dabei zumindest diejenigen Leiterzüge der integrierten Schaltung abzudecken, die kritische Signale führen. Ein aktiver Shield umfaßt dabei, wie in Figur 1 gezeigt, einen Signalsender 2, einen Signalempfänger 3, eine Ansteuer- und Auswerteeinrichtung 8 sowie zumindest zwei zwischen dem Signalsender 2 und dem Signalempfänger 3 verlaufende Leiterzüge 4, 5. In der Figur 1 sind vier parallel zueinander verlaufende Leiterzüge 4, 5 angeordnet. Die Anzahl der Leiterzüge zwischen dem Signalsender 2 und dem Signalempfänger 3 kann prinzipiell beliebig hoch sein. Vorteilhafterweise werden die Leiterzüge 4, 5 mäanderförmig oder gitterförmig in zwei oder mehreren Ebenen zueinander angeordnet sein.

In dem normalen Betriebszustand des aktiven Shields wird, wie in Figur 1 gezeigt, durch den Signalsender 2 an jeden der Leiterzüge 4, 5 ein Signal angelegt, welches bei intakten Leiterzügen 4, 5 identisch von dem Signalempfänger 3 empfangen werden muß. Die Ansteuer- und Auswerteeinrichtung 8 veranlaßt den Signalsender 2, Signale in einer vorgegebenen Höhe zu senden und wertet das von dem Signalempfänger 3 erhaltene Signal aus. Stimmen die empfangenen Signale nicht mit den gesendeten Signalen überein, so veranlaßt die Ansteuer- und Auswerteeinrichtung 8, über einen Leiterzug 14 die integrierte Schaltung 13 zu einem Funktionswechsel. Dieser kann beispielsweise darin bestehen, die in einem Speicher befindlichen Daten zu löschen oder aber einen Reset vorzunehmen.

Eine Manipulation oder Analyse der integrierten Schaltung bedingt, daß zum einen die den Halbleiterchip umgebende Abdeckmasse (in der Figur nicht gezeigt) als auch der über der integrierten Schaltung befindliche Shield entfernt beziehungsweise umgangen werden müssen. Mittels der Erfindung ist es nunmehr möglich, bereits das Entfernen der Abdeckung zu detektieren. Unter dem Begriff "Abdeckung" wird hierbei sowohl eine Abdeckmasse, z. B. ein Globe Top, als auch eine oder mehrere eventuell zusätzlich verhandene Schutzschichten auf der Passivierung der integrierten Schaltung verstanden.

Zu diesem Zweck weist die erfindungsgemäße Vorrichtung eine Schaltvorrichtung 6 auf, die in einem Teil der Leiterzüge 4, 5 vorgesehen ist. In den vorliegenden Ausführungsbeispiele weisen die mit 4 gekennzeichneten Leiterzüge derartige Schalter auf. Die mit 5 gekennzeichneten Leiterzüge sind nicht mit einem Schalter versehen. Die Schalter können als einfache Transistoren, als Logik oder als Gatter vorgesehen sein.

Die Schaltvorrichtung, das heißt die jeweiligen Schalter einer Schaltvorrichtung sind mit der Ansteuer- und Auswerteeinrichtung 8 verbunden. Ebenso ist der Signalempfänger 3 mit der Ansteuer- und Auswerteeinrichtung 8 verbunden. Der Schaltzustand wird durch die Ansteuer- und Auswerteeinrichtung 8 gesteuert. Gleichfalls wird der Signalempfänger 3 über den Zustand der Schaltvorrichtung unterrichtet, damit eine korrekte Auswertung der empfangenen Signale erfolgen kann.

In der vorliegenden Figur 1 sind die Schalter 7 der Schaltvorrichtung 6 geschlossen, so daß die Leiterzüge 4 der Ausgestaltung eines üblichen aktiven Shields entsprechen.

In der Figur 2 sind die Schalter 7 der Schaltvorrichtung 6 durch die Ansteuer- und Auswerteeinrichtung 8 derart angesteuert, daß die Leiterzüge 4 zwischen dem Signalsender und dem Signalempfänger 3 unterbrochen sind.

Erfindungsgemäß sind ein Leiterzug 4 mit Schalter 7 und ein Leiterzug 5 ohne Schalter derart benachbart zueinander angeordnet, daß im Falle eines geöffneten Schalters eine kapazitive Kopplung zwischen den Leiterzügen 4, 5 stattfinden kann. Das obere Leitungspaar verläuft im vorliegenden Beipiel unmittelbar benachbart zueinander, während zwischen den Leiterzügen 4, 5 des unteren Leitungspaares ein floatender weiterer Leitungszug vorgesehen ist. Bei dieser Variante ist eine stärkere kapazitive Kopplung während des kapazitiven Meßverfahrens möglich. Das von dem Signalsender 2 in den Leiterzug 5 eingespeiste Signal muß deshalb an den bei dem Signalempfänger 3 angeschlossenen Enden der Leiterzüge 4 und 5 empfangen werden.

Um eine Unterscheidung zwischen dem kapazitiven Meßverfahren, welches gemäß Figur 2 ausgeführt wird und dem normalen Meßverfahren gemäß Figur 1 zu erhalten, ist es vorteilhaft, im normalen Meßverfahren an den Leiterzügen 4 beziehungsweise 5 unterschiedliche Signale einzuspeisen. Im Falle des normalen Meßverfahrens muß dann am Signalempfänger 3 entsprechend ein unterschiedliches Meßsignal empfangen werden. Im Falle des kapazitiven Meßverfahrens jedoch müssen von dem Signalempfänger 3 an den Leiterzügen 4 und 5 in etwa identische Signalwerte empfangen werden.

Die Ansteuer- und Auswerteeinrichtung 8 sendet eine zufällige oder periodisch wechselnde Signalfolge an das aktive Shield, wobei dieses dann für jeweils einen vorgegebenen Zeitraum das kapazitive und dann das normale Meßverfahren durchführt, d.h. zwischen dem kapazitiven und dem normalen Meßverfahren hin und her wechselt. Mittels des kapazitiven Meßverfahrens kann das Entfernen einer Chipabdeckung, einer Kunststoffpreßmasse, eines Globe Tops, oder einer Kunststoffschutzschicht (z. B. "Imid") auf der Passivierung, aber auch die Entfernung der Passivierungsschicht selbst detektiert werden. Das normale Meßverfahren detektiert eine Beschädigung der Leiterzüge zwischen der Sende- und Empfangseinrichtung. Sind die Sende- und Empfangsdaten unterschiedlich, so wird die integrierte Schaltung in ihrem Funktionsablauf beeinflußt.

Signalempfänger 2 und Signalempfänger 3 können Bestandteil der Ansteuer- und Auswerteeinrichtung 8 sein. Diese sind vorteilhafterweise, um einer Manipulation vorzubeugen, unter den Leiterzügen des aktiven Shields angeordnet. Sie könnten sogar Bestandteile der integrierten Schaltung 13 sein.

Es wird nochmals darauf aufmerksam gemacht, daß in den vorliegenden Figuren 1 und 2, in der die integrierte Schaltung 13 neben dem aktiven Shield 1 gelegen ist, keinen Aufschluß über die räumliche Anordnung zueinander gibt. Diese Anordnung wurde lediglich einer übersichtlichen Darstellung wegen gewählt. Die Leitungen können während ihres Verlaufes zwischen dem Signalsender 2 und dem Signalempfänger 3 mehrfach die Position wechseln, wie dies in Figur 3 schematisch dargestellt ist. Die Abstände zwischen den Leitungen stellen dann statistische Mittelwerte dar.

Die Erfindung ermöglicht einen sehr sicheren Schutz gegen eine Analyse durch die Kombination zweier Detektionsverfahren. Die Vorrichtung ist durch einen minimalen zusätzlichen Hardware-Aufwand, das Vorsehen einer Schaltvorrichtung in den Leiterzügen eines aktiven Shields, realisierbar. Da die Detektionsverfahren räumlich nicht getrennt sind, ist eine lokale Angriffsstrategie nicht mehr möglich. Die Erfindung weist ferner den Vorteil auf, daß sich die beiden Meßverfahren, das kapazitive und das normale Meßverfahren, gegenseitig schützen.

### Bezugszeichenliste

- 1: Shield
- 2: Signalsender
- 3: Signalempfänger
- 4: Leiterzug
- 5: Leiterzug
- 6: Schaltvorrichtung
- 7: Schalter
- 8: Auswerte- und Austeuervorrichtung
- 9: Eingang Signalsender
- 10: Ausgang Signalempfänger
- 11: Steuereingang
- 12: Steuereingang
- 13: Integrierte Schaltung
- 14: Signalleitung
- 15: Leiterzug

## Patentansprüche

1. Vorrichtung mit einer zu schützenden, in einem Substrat ausgebildeten, integrierten Schaltung (13), einem Shield (1), das die integrierte Schaltung (13) zumindest teilweise abdeckt und das einen Signalsender (2), einen Signalempfänger (3), wenigstens zwei zwischen dem Signalsender (2) und dem Signalempfänger (3) verlaufende Leiterzüge (4, 5) und eine mit dem Signalsender (2) und dem Signalempfänger (3) verbundene Ansteuer- und Auswerteeinrichtung (8)umfaßt, sowie mit einer auf dem Substrat aufgebrachten Abdeckung,
**dadurch gekennzeichnet, daß**
das Shield (1) eine Schaltvorrichtung (6) aufweist, wodurch in einem ersten Schaltzustand ein kapazitives Meßverfahren durchführbar ist und in einem zweiten Schaltzustand eine Beschädigung des Shields (1) detektierbar ist.

2. Vorrichtung nach Anspruch 1,
**dadurch gekennzeichnet, daß**
die Schaltvorrichtung (6) in einem Teil der Leiterzüge (4,5) vorgesehen ist.

3. Vorrichtung nach Anspruch 1 oder 2,
**dadurch gekennzeichnet, daß**
die Schaltvorrichtung (6) mehrere Schalter (7) aufweist, die jeweils in einem Leiterzug (4) vorgesehen sind.

4. Vorrichtung nach einem der Ansprüche 1 bis 3,
**dadurch gekennzeichnet, daß**
jeweils zwei Leiterzüge (4, 5) derart benachbart angeordnet sind, daß eine kapazitive Kopplung möglich ist.

5. Vorrichtung nach einem der Ansprüche 1 bis 4,
**dadurch gekennzeichnet, daß**
jeweils ein Leiterzug (4) mit Schalter (7) und ein Leiterzug (5) ohne Schalter derart benachbart angeordnet sind, daß eine kapazitive Kopplung möglich ist.

6. Vorrichtung nach Anspruch 4 oder 5,
**dadurch gekennzeichnet, daß**
die zwei Leiterzüge (4, 5) unmittelbar benachbart zueinander verlaufen.

7. Vorrichtung nach Anspruch 4 oder 5,
**dadurch gekennzeichnet, daß**
zwischen den zwei Leiterzügen (4, 5) zumindest ein weiterer Leiterzug (15) gelegen ist.

8. Vorrichtung nach Anspruch 7,
**dadurch gekennzeichnet, daß**
der weitere Leiterzug (15) floatend ist.

9. Vorrichtung nach einem der Ansprüche 1 bis 8,
**dadurch gekennzeichnet, daß**
die Schalter (7) der Schaltvorrichtung (6) mit der Ansteuer- und Auswerteeinrichtung (8) verbunden sind und durch diese steuerbar sind.

10. Vorrichtung nach einem der Ansprüche 1 bis 9,
**dadurch gekennzeichnet, daß**
der Signalempfänger (3) des Shields (1) mit der Ansteuer- und Auswerteeinrichtung (8)verbunden ist.

11. Vorrichtung nach einem der Ansprüche 1 bis 10,
**dadurch gekennzeichnet, daß**
die Schaltvorrichtung (6) Teil des Signalsenders (2) ist.

12. Verfahren zum Schutz einer in einem Substrat ausgebildeten integrierten Schaltung (13) gegen "Reverse Engineering" mit einer Vorrichtung gemäß einem der Ansprüche 1 bis 8 mit den folgenden Schritten:
a) Auswahl des Schaltzustandes der Schaltvorrichtung (6) durch die Ansteuer- und Auswerteeinrichtung (8),
b) Anlegen jeweils eines Signales an die Leiterzüge (4,5) durch die Sendeeinrichtung (2),
c) Auswerten des von dem Signalempfänger (3) empfangenen Signales durch die Ansteuer- und Auswerteeinrichtung (8),
d) Herbeiführen eines Funktionswechsels der integrierten Schaltung, wenn die Auswertung des Signals durch die Ansteuer- und Auswerteeinrichtung (8), ein unerwartetes Ergebnis ergibt, und
e) Im Falle eines erwarteten Signals Wiederholen der Schritte a) bis d).

13. Verfahren nach Anspruch 12,
**dadurch gekennzeichnet, daß**
die Wahl des Schaltzustandes wahlweise oder alternierend durch die Ansteuer- und Auswertevorrichtung (8) erfolgt.

14. Vorrichtung nach Anspruch 12 oder 13,
**dadurch gekennzeichnet, daß**
der Schaltzustand periodisch oder in zufälligen Zeitabständen geändert wird.

15. Verfahren nach einem der Ansprüche 12 bis 14,
**dadurch gekennzeichnet, daß**
zumindest die an einem Leiterzug (4) mit Schalter (6) und einem benachbarten Leiterzug (5) ohne Schalter anliegende Signale unterschiedlich sind, wenn sich die Schaltvorrichtung (6) in dem zweiten Schaltzustand befindet.

## Claims

1. Apparatus having an integrated circuit (13) which is to be protected and is formed in a substrate, and having a shield (1), which at least partially covers the integrated circuit (13) and which comprises a signal transmitter (2), a signal receiver (3), at least two conductor tracks (4, 5) running between the signal transmitter (2) and the signal receiver (3) and a drive and evaluation device (8) connected to the signal transmitter (2) and the signal receiver (3), and also having a covering applied on the substrate,
**characterized in that**
the shield (1) has a switching apparatus (6), as a result of which a capacitive measurement method can be carried out in a first switching state and damage to the shield (1) can be detected in a second switching state.

2. Apparatus according to Claim 1,
**characterized in that**
the switching apparatus (6) is provided in a portion of the conductor tracks (4, 5).

3. Apparatus according to Claim 1 or 2,
**characterized in that**
the switching apparatus (6) has a plurality of switches (7) which are in each case provided in a conductor track (4).

4. Apparatus according to one of Claims 1 to 3,
**characterized in that**
in each case two conductor tracks (4, 5) are arranged adjacent in such a way that a capacitive coupling is possible.

5. Apparatus according to one of Claims 1 to 4,
**characterized in that**
in each case a conductor track (4) with a switch (7) and a conductor track (5) without a switch are arranged adjacent in such a way that a capacitive coupling is possible.

6. Apparatus according to Claim 4 or 5,
**characterized in that**
the two conductor tracks (4, 5) run directly adjacent to one another.

7. Apparatus according to Claim 4 or 5,
**characterized in that**
at least one further conductor track (15) is located between the two conductor tracks (4, 5).

8. Apparatus according to Claim 7,
**characterized in that**
the further conductor track (15) is floating.

9. Apparatus according to one of Claims 1 to 8,
**characterized in that**
the switches (7) of the switching apparatus (6) are connected to the drive and evaluation device (8) and can be controlled by the latter.

10. Apparatus according to one of Claims 1 to 9,
**characterized in that**
the signal receiver (3) of the shield (1) is connected to the drive and evaluation device (8).

11. Apparatus according to one of Claims 1 to 10,
**characterized in that**
the switching apparatus (6) is part of the signal transmitter (2) .

12. Method for protecting an integrated circuit (13) formed in a substrate against "reverse engineering" with an apparatus according to one of Claims 1 to 8, having the following steps:
a) selection of the switching state of the switching apparatus (6) by the drive and evaluation device (8),
b) application of a respective signal to the conductor tracks (4, 5) by the transmitting device (2),
c) evaluation of the signal received by the signal receiver (3) by the drive and evaluation device (8),
d) initiation of a function change of the integrated circuit if the evaluation of the signal by the drive and evaluation device (8) produces an unexpected result,
e) in the case of an expected signal repetition of steps a) to d).

13. Method according to Claim 12,
**characterized in that**
the switching state is selected optionally or alternately by the drive and evaluation apparatus (8).

14. Apparatus according to Claim 12 or 13,
**characterized in that**
the switching state is changed periodically or at random time intervals.

15. Method according to one of Claims 12 to 14,
**characterized in that**
at least the signals present on a conductor track (4) with a switch (6) and an adjacent conductor track (5) without a switch are different if the switching apparatus (6) is in the second switching state.

## Revendications

1. Dispositif comprenant un circuit intégré (13) à protéger qui est conçu dans un substrat, un blindage (1) qui couvre au moins partiellement le circuit intégré (13) et qui comprend un émetteur de signal (2), un récepteur de signal (3), au moins deux tracés conducteurs (4, 5) s'étendant entre l'émetteur de signal (2) et le récepteur de signal (3) ainsi qu'un dispositif de commande et d'évaluation (8) relié à l'émetteur de signal (2) et au récepteur de signal (3), ainsi qu'avec un revêtement appliqué sur le substrat,
**caractérisé par le fait que** le blindage (1) comporte un dispositif de commutation (6) tel que, dans un premier état de commutation, un procédé de mesure capacitif peut être mis en oeuvre et, dans un deuxième état de commutation, un endommagement du blindage (1) peut être détecté.

2. Dispositif selon la revendication 1,
**caractérisé par le fait que** le dispositif de commutation (6) est prévu dans une partie des tracés conducteurs (4, 5).

3. Dispositif selon la revendication 1 ou 2,
**caractérisé par le fait que** le dispositif de commutation (6) comporte plusieurs interrupteurs (7) qui sont prévus à chaque fois dans un tracé conducteur (4).

4. Dispositif selon l'une des revendications 1 à 3,
**caractérisé par le fait que**, à chaque fois, deux tracés conducteurs (4, 5) sont disposés au voisinage l'un de l'autre de sorte qu'un couplage capacitif est possible.

5. Dispositif selon l'une des revendications 1 à 4,
**caractérisé par le fait que**, à chaque fois, un tracé conducteur (4) avec interrupteurs (7) et un tracé conducteur (5) sans interrupteur sont disposés au voisinage l'un de l'autre de sorte qu'un couplage capacitif est possible.

6. Dispositif selon la revendication 4 ou 5,
**caractérisé par le fait que** les deux tracés conducteurs (4, 5) s'étendent au voisinage direct l'un de l'autre.

7. Dispositif selon la revendication 4 ou 5,
**caractérisé par le fait qu'**au moins un autre tracé conducteur (15) est placé entre les deux tracés conducteurs (4, 5).

8. Dispositif selon la revendication 7,
**caractérisé par le fait que** l'autre tracé conducteur (15) est flottant.

9. Dispositif selon l'une des revendications 1 à 8,
**caractérisé par le fait que** les interrupteurs (7) du dispositif de commutation (6) sont reliés à un dispositif de commande et d'évaluation (8) et peuvent être commandés par celui-ci.

10. Dispositif selon l'une des revendications 1 à 9,
**caractérisé par le fait que** le récepteur de signal (3) du blindage (1) est relié au dispositif de commande et d'évaluation (8).

11. Dispositif selon l'une des revendications 1 à 10,
**caractérisé par le fait que** le dispositif de commutation (6) fait partie de l'émetteur de signal (2).

12. Procédé de protection d'un circuit intégré (13) conçu dans un substrat contre toute rétro-conception du type "Reverse Engineering" avec un dispositif selon l'une des revendications 1 à 8 et avec les étapes suivantes :
a) sélection de l'état de commutation du dispositif de commutation (6) par le dispositif de commande et d'évaluation (8),
b) application à chaque fois d'un signal aux tracés conducteurs (4, 5) par le dispositif émetteur (2),
c) évaluation du signal reçu par le récepteur de signal (3) au moyen du dispositif de commande et d'évaluation (8),
d) déclenchement d'un changement de fonction du circuit intégré lorsque l'évaluation du signal par le dispositif de commande et d'évaluation (8) donne un résultat inattendu, et
e) dans le cas d'un signal attendu, répétition des étapes a) à d).

13. Dispositif selon la revendication 12,
**caractérisé par le fait que** le choix de l'état de commutation est effectué sélectivement ou alternativement par le dispositif de commande et d'évaluation (8).

14. Dispositif selon la revendication 12 ou 13,
**caractérisé par le fait que** l'état de commutation est modifié périodiquement ou à intervalles de temps aléatoires.

15. Dispositif selon l'une des revendications 12 à 14,
**caractérisé par le fait qu'**au moins les signaux présents sur un tracé conducteur (4) avec interrupteurs (6) et sur un tracé conducteur voisin (5) sans interrupteur sont différents lorsque le dispositif de commutation (6) se trouve dans le deuxième état de commutation.
